# FASCICULE DE BREVET EUROPEEN

(11) **EP 3 175 547 B1**
(45) Date de publication et mention de la délivrance du brevet: **09.05.2018**
(21) Numéro de dépôt: 15742254.4
(22) Date de dépôt: 27.07.2015
(51) Int. Cl.: H02S 20/20, H02S 20/21, H01L 31/048

(54) **ENSEMBLE COMPORTANT UN MODULE PHOTOVOLTAÏQUE APPLIQUÉ SUR UNE ZONE CIRCULABLE**
AUF EINE KREISVERKEHRSZONE ANGEWANDTE ANORDNUNG MIT EINEM PHOTOVOLTAIKMODUL
ASSEMBLY INCLUDING A PHOTOVOLTAIC MODULE APPLIED TO A CIRCULABLE ZONE

(30) Priorité: 28.07.2014 FR 1457275
(43) Date de publication de la demande: 07.06.2017
(73) Titulaire: Commissariat à l'Énergie Atomique et aux Énergies Alternatives, 75015 Paris (FR); COLAS, 92100 Boulogne-Billancourt (FR)
(72) Inventeur: GAUME, Julien, 38110 La Tour Du Pin (FR); COQUELLE, Eric, 78000 Versailles (FR); GAUTIER, Jean-Luc, 78280 Guyancourt (FR); GUILLEREZ, Stéphane, 73610 Lepin Le Lac (FR); SICOT, Lionel, 73000 Chambery (FR)
(74) Mandataire: Brevalex
(86) Numéro de dépôt international: PCT/EP2015/067109
(87) Numéro de publication internationale: WO 2016/016165

(56) Documents cités:
- JP-A- H0 918 041
- JP-A- 2013 038 228
- US-A1- 2005 199 282
- US-A1- 2010 154 867
- US-A1- 2012 260 975
- Dominique Jousset ET AL: "Nanostructured copolymers : bloc copolymers (Nanostrength) and grafted copolymers (Apolhya)", INNOV'DAYS LES NANOMATERIAUX EN PLASTURGIE, 22 novembre 2012 (2012-11-22), XP055181464, Dijon Extrait de l'Internet: URL:http://www.innovdays-plasturgie.com/in novdays/Illustrations/Documents/InnovDays/ 2012/20121122_Nanomateriaux/5_ARKEMA-Apolh ya_nov12.pdf [extrait le 2015-04-08]

## Description

### DOMAINE TECHNIQUE

La présente invention se rapporte au domaine des modules photovoltaïques, comportant un ensemble de cellules photovoltaïques reliées entre elles électriquement, et notamment des cellules photovoltaïques dites « cristallines », c'est-à-dire qui sont à base de cristaux de silicium ou de polycristaux de silicium.

L'invention peut être mise en oeuvre pour de nombreuses applications, étant particulièrement concernée par les applications qui requièrent l'utilisation de modules photovoltaïques légers, flexibles et robustes vis-à-vis de chocs et de charges mécaniques élevées. Elle trouve ainsi une application privilégiée pour son intégration sur des zones circulables, pour des piétons et/ou des véhicules, telles que des chaussées ou routes, des pistes cyclables, des plateformes industrielles, des places, des trottoirs, entre autres. Une telle application est couramment désignée par l'expression de « route solaire ».

L'invention propose ainsi un ensemble de structure photovoltaïque comportant un module photovoltaïque appliqué sur une zone circulable, l'utilisation d'un tel module photovoltaïque pour son application sur une zone circulable, ainsi qu'un procédé de réalisation d'un tel ensemble de structure photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur de l'ordre de 3 mm. La deuxième couche formant la face arrière du module photovoltaïque peut quant à elle être réalisée à base de verre, de métal ou de plastique, entre autres. Elle est habituellement formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 300 µm.

Les cellules photovoltaïques peuvent être reliées électriquement en série entre elles par des éléments de contact électrique avant et arrière, appelés conducteurs de liaison, et formés par exemple par des bandes de cuivre, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, sont encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'EVA peut présenter une épaisseur d'au moins 0,3 mm et un module de Young inférieur ou égal à 30 MPa à température ambiante.

Habituellement encore, le procédé de réalisation du module photovoltaïque comporte une seule étape de laminage des différentes couches décrites précédemment, à une température supérieure ou égale à 140°C, voire 150°C, et pendant une période d'au moins 8 minutes, voire 15 minutes. Après cette opération de laminage, les deux couches d'EVA ont fondu pour ne former qu'une seule couche dans laquelle sont noyées les cellules photovoltaïques.

Néanmoins, ces réalisations connues de l'art antérieur d'un module photovoltaïque ne sont pas entièrement satisfaisantes et présentent plusieurs inconvénients pour au moins certaines de leurs applications.

Dans le cadre de l'application du type route solaire, un besoin est apparu pour utiliser les routes ou chaussées comme moyens de production d'énergie pendant la journée, que ce soit pour alimenter des bâtiments situés à proximité (entreprises, éco-quartiers, fermes solaires, maisons individuelles, entre autres) ou pour alimenter le réseau électrique ou des dispositifs d'aide à la circulation, par exemple.

Ainsi, tout d'abord, la présence d'une plaque de verre pour former la face avant du module photovoltaïque n'est pas compatible avec certaines applications du module photovoltaïque qui peuvent requérir une relative légèreté et une facilité de mise en forme du module. Au contraire, les conceptions de l'art antérieur utilisant du verre en face avant des modules photovoltaïques impliquent l'obtention d'un poids élevé du module et une capacité d'intégration limitée.

Pour une application du type route solaire, les modules photovoltaïques avec une face avant réalisée en verre ne sont, d'une part, pas suffisamment flexibles pour répondre à la déformation d'une route, celle-ci étant de l'ordre d'1 mm tous les 100 mm pour les deux axes horizontaux, selon la largeur et la longueur, de la route. D'autre part, ces modules photovoltaïques ne sont pas suffisamment résistants à la charge statique s'ils sont collés directement sur la chaussée. Autrement dit, la rugosité de la chaussée peut provoquer un poinçonnement des cellules photovoltaïques par la face arrière du module photovoltaïque, entraînant alors des risques de cassure des cellules photovoltaïques.

Des solutions ont été envisagées pour remplacer la face avant en verre des modules photovoltaïques par des matériaux plastiques, tout en conservant l'architecture et la méthode de réalisation classiques des modules photovoltaïques. A titre d'exemples, la demande de brevet FR 2 955 051 A1 et les demandes internationales WO 2012/140585 A1 et WO 2011/028513 A2 décrivent des possibilités d'alternatives au verre pour concevoir la face avant des modules photovoltaïques, parmi lesquelles l'utilisation de feuilles de polymère, d'une épaisseur inférieure ou égale à 500 µm, comme le polyfluorure de vinylidène (PVDF), l'éthylène tétrafluoroéthylène (ETFE), le polyméthacrylate de méthyle (PMMA) ou encore le polycarbonate (PC).

Cependant, la simple substitution du verre par un matériau polymère, afin d'obtenir un module photovoltaïque léger et flexible, entraîne généralement une vulnérabilité accrue du module aux chocs et aux charges mécaniques, non acceptable pour certaines applications.

De plus, dans ces exemples de réalisation de l'art antérieur, la face avant (dépourvue de verre) de chaque module photovoltaïque est continue, c'est-à-dire qu'elle forme une feuille ou une plaque unitaire qui recouvre l'ensemble du module. De la sorte, la flexibilité de chaque module photovoltaïque peut être limitée et surtout non suffisante. Par ailleurs, cela pose également un problème d'accentuation de contraintes différentielles de dilatation entre les différentes couches de la structure, pouvant conduire à des déformations ou des décollements indésirables aux interfaces de la structure, comme par exemple à l'interface encapsulant/couches externes.

Il a été proposé certaines solutions visant à obtenir une relative discontinuité de la face avant d'un module photovoltaïque afin d'obtenir une meilleure flexibilité du module et de mieux gérer les contraintes de dilatation différentielle. Ainsi, par exemple, la demande de brevet US 2014/0000683 A1 décrit une méthode pour encapsuler des cellules photovoltaïques de manière individuelle. Les cellules encapsulées peuvent ensuite être interconnectées pour obtenir un module photovoltaïque souple. Par ailleurs, la demande de brevet US 2014/0030841 A1 enseigne la mise en oeuvre d'un module photovoltaïque sur un substrat flexible. Le module photovoltaïque est composé de « sous-modules » constitués de cellules photovoltaïques interconnectées, chaque sous-module étant indépendant électriquement des sous-modules voisins. Par ailleurs, la demande de brevet JP 2013/038228 A divulgue un module photovoltaïque flexible sur une zone circulable. Toutefois, les solutions décrites ci-dessus ne s'avèrent pas totalement satisfaisantes en termes de flexibilité, de résistance aux chocs et aux charges mécaniques, de performance et de coût des modules photovoltaïques, en particulier pour des applications contraignantes qui les sollicitent fortement au niveau de leur résistance mécanique.

### EXPOSÉ DE L'INVENTION

Il existe ainsi un besoin pour proposer une solution alternative de conception d'un ensemble muni d'un module photovoltaïque appliqué sur une zone circulable pour répondre à au moins certaines contraintes inhérentes aux applications visées par l'utilisation du module photovoltaïque, en particulier pour améliorer la flexibilité, la rigidité, la légèreté et la résistance aux chocs et charges mécaniques du module photovoltaïque. Il existe notamment un besoin pour perfectionner encore les modules photovoltaïques destinés à être intégrés sur des zones circulables, pour des piétons et/ou véhicules, par exemple pour augmenter leur résistance à la charge induite par le passage d'un véhicule tout en présentant une certaine flexibilité.

L'invention a pour but de remédier au moins partiellement aux besoins mentionnés ci-dessus et aux inconvénients relatifs aux réalisations de l'art antérieur.

L'invention a ainsi pour objet, selon l'un de ses aspects, un ensemble de structure photovoltaïque, comportant :
- une zone circulable,
- un module photovoltaïque appliqué sur la zone circulable,
   le module photovoltaïque comportant au moins :
   - une première couche transparente formant la face avant du module photovoltaïque destinée à recevoir un flux lumineux,
   - un ensemble d'une pluralité de cellules photovoltaïques disposées côte à côte et reliées électriquement entre elles,
   - un ensemble encapsulant la pluralité de cellules photovoltaïques,
   - une deuxième couche formant la face arrière du module photovoltaïque, destinée en particulier à être solidarisée à une zone circulable, l'ensemble encapsulant et l'ensemble d'une pluralité de cellules photovoltaïques étant situés entre les première et deuxième couches, et
- une couche de fixation, constituée notamment par une colle bitumeuse ou par une ou des résines acryliques, située entre la zone circulable et le module photovoltaïque, permettant l'adhérence du module photovoltaïque à la zone circulable, caractérisé en ce que la première couche est constituée d'au moins un matériau polymère transparent et comporte une pluralité de plaques indépendantes les unes des autres, chaque plaque étant située en regard d'au moins une cellule photovoltaïque, de sorte à former une face avant discontinue du module photovoltaïque,
et en ce que la rigidité de l'ensemble encapsulant est définie par un module de Young du matériau d'encapsulation supérieur ou égal à 75 MPa à température ambiante et une épaisseur de la couche comprise entre 0,4 et 1 mm.

Initialement, c'est-à-dire avant toute opération de laminage, l'ensemble encapsulant est constitué par deux couches de matériau d'encapsulation, dites couches de coeur, entre lesquelles l'ensemble d'une pluralité de cellules photovoltaïques est encapsulé. Toutefois, après l'opération de laminage des couches, les couches de matériau d'encapsulation ont fondu pour ne former qu'une seule couche (ou ensemble) dans laquelle sont noyées les cellules photovoltaïques. Avant toute opération de laminage, chaque couche de matériau d'encapsulation peut ainsi présenter une rigidité définie par un module de Young du matériau d'encapsulation supérieur ou égal à 75 MPa à température ambiante et une épaisseur de la couche comprise entre 0,2 et 1 mm, voire entre 0,2 et 0,5 mm.

L'ensemble encapsulant la pluralité de cellules photovoltaïques est ainsi constitué par les deux couches de matériau d'encapsulation, à savoir les couches de matériau d'encapsulation qui avant laminage sont en contact direct avec les cellules photovoltaïques.

Le terme « transparent » signifie que le matériau de la première couche formant la face avant du module photovoltaïque est au moins partiellement transparent à la lumière visible, laissant passer au moins environ 80 % de cette lumière.

De plus, par l'expression « plaques indépendantes les unes des autres », on entend que les plaques sont situées à distance les unes des autres, formant chacune un élément unitaire indépendant de la première couche et les uns des autres, superposé à au moins une cellule photovoltaïque. La réunion de l'ensemble de ces plaques forme alors la première couche avec un aspect discontinu.

En outre, par le terme « encapsulant » ou « encapsulé », il faut comprendre que l'ensemble d'une pluralité de cellules photovoltaïques est disposé dans un volume, par exemple hermétiquement clos, au moins en partie formé par les couches de matériau d'encapsulation, réunies entre elles après laminage.

Par ailleurs, l'expression « zone circulable » désigne toute zone prévue pour la circulation de piétons et/de véhicules, telles que par exemple une chaussée (ou route), une autoroute, une piste cyclable, une plateforme industrielle, une place, un trottoir, cette liste étant nullement limitative.

De plus, par l'expression « température ambiante », on entend une température comprise entre environ 15 et 30°C.

Grâce à l'invention, il peut ainsi être possible d'apporter une solution alternative pour la conception d'un ensemble de structure photovoltaïque comportant un module photovoltaïque souple et relativement flexible, et également suffisamment robuste pour résister à des chocs et des charges mécaniques subis, notamment après application sur la zone circulable. En particulier, l'utilisation d'une face avant discontinue peut conférer au module photovoltaïque un caractère flexible permettant notamment de faciliter son application sur un support non plan, par exemple courbé. De plus, l'utilisation d'un matériau d'encapsulation de rigidité élevée de part et d'autre des cellules photovoltaïques peut permettre de protéger convenablement les cellules photovoltaïques contre le risque d'une forte charge mécanique ou d'un choc, en limitant leur flexion, et donc en limitant le risque de cassure. En outre, l'absence d'usage d'un matériau en verre pour la face avant du module photovoltaïque peut permettre au module photovoltaïque de présenter un poids inférieur à celui d'un module photovoltaïque selon l'art antérieur, typiquement de l'ordre de 12kg/m², en fonction de l'épaisseur des différentes couches utilisées. Enfin, l'utilisation d'une face avant discontinue en un matériau polymère peut permettre de se prémunir de problèmes de dilatation thermique au cours de l'emploi du module photovoltaïque en extérieur. En effet, la dilatation thermique étant proportionnelle aux dimensions de la première couche formant la face avant du module, le fait d'utiliser des plaques ayant des dimensions proches de celles des cellules photovoltaïques peut permettre de limiter significativement les déplacements induits par des contraintes thermiques pouvant donner lieu à des délaminations ou une conformation non contrôlée du module photovoltaïque.

L'ensemble de structure photovoltaïque selon l'invention peut en outre comporter l'une ou plusieurs des caractéristiques suivantes prises isolément ou suivant toutes combinaisons techniques possibles.

La deuxième couche formant la face arrière du module photovoltaïque peut également être discontinue. Autrement dit, la deuxième couche peut également comporter une pluralité de plaques indépendantes les unes des autres, chaque plaque étant située en regard, c'est-à-dire superposée, d'au moins une cellule photovoltaïque. La présence d'une face arrière discontinue sur le module photovoltaïque peut par exemple permettre d'améliorer encore la flexibilité du module pour faciliter son application sur une zone circulable pourvue d'une rugosité de surface.

Par ailleurs, quand bien même la première couche formant la face avant du module photovoltaïque, et éventuellement la deuxième couche formant la face arrière du module, présentent un aspect discontinu, l'ensemble d'une pluralité de cellules photovoltaïques et l'ensemble encapsulant sont avantageusement continues.

Selon un mode de réalisation particulier de l'invention, chaque plaque de la première couche, et éventuellement de la deuxième couche, peut être située en regard de plusieurs cellules photovoltaïques. Cela peut notamment être le cas pour des cellules photovoltaïques de dimensions plus faibles que celles des cellules photovoltaïques classiques, typiquement de 156 x 156 mm.

De plus, lorsqu'une seule cellule photovoltaïque est située en regard de chaque plaque de la première couche, et éventuellement de la deuxième couche, chaque plaque peut présenter des dimensions au moins égales à celles de la cellule photovoltaïque à laquelle elle est superposée.

Le module photovoltaïque est avantageusement dépourvu d'une première couche formant la face avant du module réalisée en verre. Ainsi, comme indiqué précédemment, il peut être possible d'améliorer la légèreté et la capacité d'intégration du module photovoltaïque.

Le matériau d'encapsulation formant les deux couches de matériau d'encapsulation de coeur de l'ensemble encapsulant peut présenter un module de Young à température ambiante supérieur ou égal à 100 MPa, notamment supérieur ou égal à 150 MPa, voire 200 MPa. Il est notamment de 220 MPa.

L'ensemble encapsulant peut être formé à partir de deux couches de matériau d'encapsulation ayant des épaisseurs identiques ou différentes.

La deuxième couche formant la face arrière du module photovoltaïque peut être constituée de façon préférentielle d'au moins un matériau composite, notamment du type polymère/fibres de verre.

La deuxième couche a par ailleurs, de préférence, un coefficient de dilatation thermique inférieur ou égal à 20 ppm, et de préférence inférieur ou égal à 10 ppm.

La deuxième couche formant la face arrière du module photovoltaïque peut être ou non transparente.

La rigidité de la deuxième couche formant la face arrière du module photovoltaïque peut être définie par un facteur de rigidité, correspondant au module de Young à température ambiante du matériau de la deuxième couche multiplié par l'épaisseur de la deuxième couche, compris entre 5 et 15 GPa.mm.

De plus, la rigidité de la deuxième couche formant la face arrière du module photovoltaïque peut être définie par un module de Young à température ambiante du matériau de la deuxième couche supérieur ou égal à 1 GPa, mieux supérieur ou égal à 3 GPa, encore mieux supérieur ou égal à 10 GPa, et une épaisseur de la deuxième couche comprise entre 0,2 et 3 mm.

De cette façon, la deuxième couche formant la face arrière du module photovoltaïque peut présenter une rigidité élevée, pouvant limiter ainsi sa flexibilité. Toutefois, cette rigidité élevée peut permettre de réduire, voire d'empêcher, le poinçonnement des cellules photovoltaïques par la face arrière du module, c'est-à-dire l'apparition de fissures et/ou de cassures des cellules photovoltaïques, lorsque celui-ci est appliqué sur un support présentant une rugosité de surface importante.

L'espacement entre deux cellules photovoltaïques voisines, ou encore consécutives ou adjacentes, peut être supérieur ou égal à 1 mm, notamment compris entre 1 et 30 mm, et de préférence supérieur ou égal à 3 mm, notamment compris entre 10 et 20 mm.

Les deux cellules photovoltaïques voisines considérées peuvent être deux cellules voisines d'une même série (encore désignée par le terme « string » en anglais) ou deux cellules voisines appartenant respectivement à deux séries consécutives de l'ensemble de cellules photovoltaïques.

La présence d'un important espacement entre les cellules photovoltaïques peut permettre d'obtenir un espacement également important entre les plaques de la première couche formant la face avant du module photovoltaïque. De cette façon, l'aspect discontinu de la face avant du module est accentué, permettant ainsi de conférer une flexibilité au module pour faciliter son application sur la zone circulable.

De façon avantageuse, l'espacement entre deux plaques voisines de la première couche, et éventuellement de la deuxième couche, est inférieur ou égal à l'espacement entre deux cellules photovoltaïques voisines.

Le module peut par ailleurs comporter de façon préférentielle une couche intermédiaire dite « amortissante » située entre la première couche formant la face avant du module photovoltaïque et l'ensemble encapsulant la pluralité de cellules photovoltaïques, permettant l'assemblage, notamment par collage, de la première couche sur l'ensemble encapsulant.

La couche intermédiaire peut être constituée d'au moins un matériau polymère, notamment d'une résine polymère thermoplastique ou thermodurcissable.

La couche intermédiaire peut se présenter par exemple sous forme de feuille ou sous forme liquide. Elle peut être adhésive, par exemple du type PSA, ou non. Elle peut être mise en oeuvre à chaud ou encore à température ambiante.

La rigidité de la couche intermédiaire peut être définie par un module de Young du matériau de la couche intermédiaire inférieur ou égal à 50 MPa à température ambiante et une épaisseur de la couche intermédiaire comprise entre 0,01 et 1 mm.

La couche intermédiaire peut en particulier remplir deux fonctions principales. D'une part, elle peut permettre l'adhésion de la première couche formant la face avant du module photovoltaïque sur l'ensemble encapsulant pour le cas où les deux couches ne sont pas compatibles chimiquement. D'autre part, elle peut permettre de créer au sein du module photovoltaïque une couche « amortissante » d'une certaine souplesse permettant d'améliorer la résistance aux chocs et aux charges mécaniques du module.

Cette couche intermédiaire peut être optionnelle, en particulier absente lorsqu'il y a compatibilité chimique entre la première couche formant la face avant du module photovoltaïque et l'ensemble encapsulant.

Le module photovoltaïque peut en outre comporter une couche adhésive située entre la deuxième couche formant la face arrière du module photovoltaïque et l'ensemble encapsulant la pluralité de cellules photovoltaïques, permettant l'assemblage, notamment par collage, de la deuxième couche sur l'ensemble encapsulant.

Par « couche adhésive », on entend une couche permettant, une fois le module photovoltaïque réalisé, à la deuxième couche d'adhérer à l'ensemble encapsulant. Il s'agit ainsi d'une couche permettant une compatibilité chimique et une adhésion entre l'encapsulant et la face arrière.

Par ailleurs, l'épaisseur de la première couche formant la face avant du module photovoltaïque peut être supérieure ou égale à 0,1 mm, notamment comprise entre 0,5 et 6 mm.

La zone circulable peut présenter une rugosité de surface.

Par ailleurs, comme indiqué précédemment, l'ensemble comporte une couche de fixation, notamment par collage, située entre la zone circulable et le module photovoltaïque. L'utilisation de la couche de fixation peut permettre d'obtenir une face arrière du module photovoltaïque renforcée, permettant d'éviter le risque de poinçonnement des cellules photovoltaïques par la face arrière lorsque la zone circulable présente une rugosité de surface élevée et que le module photovoltaïque est soumis à un choc ou une charge mécanique élevée. En effet, l'interface entre la face arrière du module et la zone circulable peut ainsi être comblée par un liant de protection.

La couche de fixation peut comporter une colle, par exemple une colle époxy ou polyuréthane, entre autres. Elle peut en particulier comporter une colle industrielle spéciale.

La couche de fixation peut aussi comporter un liant bitumeux, éventuellement renforcé par un ajout d'un polymère tel que du Styrène-Butadiène-Styrène (SBS), à chaud ou en émulsion.

Selon une réalisation, la couche de fixation est directement répandue sur la surface de la zone circulable, étalée en couche mince, puis le module photovoltaïque y est déposé alors que la colle n'a pas durcie ou que le liant bitumeux est encore visqueux et collant.

De plus, l'ensemble peut comporter une couche de revêtement, permettant notamment le passage de piétons et/ou de véhicules, appliquée sur la première couche formant la face avant du module photovoltaïque, la couche de revêtement étant non opaque et présentant une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV (pour « Polished Stone Value » en anglais) selon la norme NF EN 13043 d'au moins PSV₄₄, mieux PSV₅₀, encore mieux PSV₅₃.

La couche de revêtement peut avantageusement présenter une surface extérieure reproduisant la texture d'un enduit superficiel routier et circulable.

Par le terme « irrégulièrement », on entend que les reliefs donnant la macrotexture et la microtexture à la couche de revêtement n'ont pas tous la même forme, ni la même taille. Ces reliefs peuvent être obtenus à partir d'éléments texturants n'ayant pas la même forme ni la même taille, étant non calibrés.

La couche de revêtement présente avantageusement un taux de transparence supérieur à 50 %, par exemple compris entre 50 et 95 %, dans une plage de 100 nm autour du pic d'efficacité des cellules photovoltaïques, notamment dans la plage 500-700 nm.

La profondeur moyenne de texture PMT de la couche de revêtement peut être d'au moins 0,30 mm, mieux d'au moins 0,6 mm.

De plus, la couche de revêtement peut comporter une matrice non opaque, de préférence de module de Young à température ambiante compris entre 0,1 et 10 GPa. La matrice peut être choisie parmi les matériaux d'origine synthétique ou végétale, les liants bitumineux, de préférence de classe de pénétrabilité selon la norme EN 1426 160/220, 100/150, 70/100, 50/70, 40/60, 35/50, 30/45 ou 20/30 (en dixième de mm), les liants routiers clairs de synthèse ou d'origine végétale, de préférence de classe de pénétrabilité selon la norme EN 1426 160/220, 100/150, 70/100, 50/70, 40/60, 35/50, 30/45 ou 20/30 (en dixième de mm) et les liants polymériques.

La texture de la surface extérieure de la couche de revêtement peut être définie au moins partiellement par des éléments texturants non opaques, de préférence de forme irrégulière, mieux aléatoire. Les éléments texturants peuvent être disposés selon une monocouche, de préférence enfoncés à mi-épaisseur environ dans la matrice de la couche de revêtement. Ces éléments texturants peuvent être choisis parmi les granulats de matériaux transparents ou translucides, organiques ou minéraux, notamment de polycarbonate ou de verre. Ils peuvent avoir une taille allant de 0,1 mm à 10 mm, mieux de 0,4 à 4 mm, encore mieux de 0,9 à 1,4 mm.

La couche de revêtement peut par exemple être un liant de type bitumineux tel que défini dans la norme NF EN 12591, tel que le liant Bituclair commercialisé par la société Colas.

La couche de revêtement peut encore être un liant routier clair de synthèse ou d'origine végétale, tels que les liants Végécol ou Végéclair commercialisés par la société Colas.

La couche de revêtement peut également être un liant de nature purement synthétique ou d'origine végétale, le liant étant de préférence de nature organique, préférentiellement de nature polymérique, tel qu'une résine acrylique, époxy ou polyuréthane, comme les vernis époxydiques dits Vernis D commercialisés par la société Résipoly, ou encore un polyuréthane Sovermol commercialisé par la société BASF.

De façon préférentielle, les cellules photovoltaïques sont des cellules dites « cristallines », c'est-à-dire à base de cristaux de silicium ou de polycristaux de silicium.

En outre, l'invention a également pour objet, selon un autre de ses aspects, l'utilisation, pour son application sur une zone circulable, notamment une chaussée, d'un module photovoltaïque comportant au moins :
- une première couche transparente formant la face avant du module photovoltaïque destinée à recevoir un flux lumineux,
- un ensemble d'une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et l'ensemble d'une pluralité de cellules photovoltaïques étant situés entre les première et deuxième couches,
la première couche étant constituée d'au moins un matériau polymère transparent et comportant une pluralité de plaques indépendantes les unes des autres, chaque plaque étant située en regard d'au moins une cellule photovoltaïque, de sorte à former une face avant discontinue du module photovoltaïque,
et la rigidité de l'ensemble encapsulant étant définie par un module de Young du matériau d'encapsulation supérieur ou égal à 75 MPa à température ambiante et une épaisseur de l'ensemble encapsulant comprise entre 0,4 et 1 mm,
le module photovoltaïque étant appliqué sur la zone circulable par l'intermédiaire d'une couche de fixation, constituée notamment par une colle bitumeuse ou par une ou des résines acryliques.

Par ailleurs, l'invention a encore pour objet, selon un autre de ses aspects, un procédé de réalisation d'un ensemble de structure photovoltaïque tel que défini précédemment, comportant au moins les quatre étapes successives suivantes de :
a) laminage à chaud à une température supérieure à 150°C de l'ensemble des couches constitutives du module photovoltaïque hormis la première couche formant la face avant du module photovoltaïque et une éventuelle couche intermédiaire dite « amortissante », située entre la première couche et l'ensemble encapsulant la pluralité de cellules photovoltaïques,
b) laminage à une température inférieure ou égale à 150°C, mieux 125°C, par exemple à température ambiante, de la première couche formant la face avant du module photovoltaïque, et de l'éventuelle couche intermédiaire, sur les couches constitutives du module photovoltaïque laminées ensemble au cours de la première étape a),
c) application d'une couche de revêtement sur la première couche formant la face avant du module photovoltaïque, notamment pour permettre le passage de piétons et/ou de véhicules, la couche de revêtement étant non opaque et présentant une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV (pour « Polished Stone Value » en anglais) selon la norme NF EN 13043 d'au moins PSV₄₄, mieux PSV₅₀, encore mieux PSV₅₃,
d) fixation du module photovoltaïque sur une zone circulable pour former l'ensemble de structure photovoltaïque, au moyen d'une couche de fixation de l'ensemble de structure photovoltaïque, constituée notamment par une colle bitumeuse ou par une ou des résines acryliques.

Lors de la première étape a) de laminage, les couches constitutives du module photovoltaïque concernées sont ainsi l'ensemble d'une pluralité de cellules photovoltaïques, l'ensemble encapsulant et la deuxième couche formant la face arrière du module photovoltaïque.

De plus, avant la mise en oeuvre de la deuxième étape b), les plaques de la première couche peuvent avantageusement être traitées à l'aide d'un équipement de traitement Corona de manière à obtenir une énergie de surface supérieure ou égale à 48 dyn/cm.

L'éventuelle couche intermédiaire dite « amortissante » peut permettre de faciliter le collage de la première couche formant la face avant du module sur les autres couches. Cette couche intermédiaire est optionnelle. Elle peut notamment ne pas être nécessaire lorsqu'il existe une compatibilité chimique entre la première couche formant la face avant du module et l'ensemble encapsulant.

Comme indiqué précédemment, l'épaisseur de l'ensemble encapsulant peut être comprise entre 0,4 et 1 mm, celui-ci résultant de l'association par laminage d'au moins deux couches de matériau d'encapsulation présentant chacune une épaisseur comprise entre 0,2 et 0,5 mm. Ces deux couches de matériau d'encapsulation peuvent par ailleurs présenter des épaisseurs différentes.

Avantageusement, la mise en oeuvre d'au moins deux étapes de laminage dans le procédé selon l'invention pour la réalisation du module photovoltaïque peut permettre de s'affranchir d'éventuels problèmes de dilatation thermique pouvant survenir du fait de l'utilisation d'une face avant du module en un matériau polymère.

En effet, certaines couches du module photovoltaïque nécessitent d'être laminées à une température supérieure ou égale à 140°C, voire 150°C, mais le laminage à ce niveau de température en une seule étape, conformément à la pratique selon l'art antérieur, de l'ensemble des couches du module, y compris celle formant la face avant du module, peut donner lieu à une conformation non contrôlée et à des délaminations importantes de la face avant du module photovoltaïque à cause de contraintes mécaniques engendrées trop importantes.

Aussi, la présence d'au moins une deuxième étape de laminage à plus basse température que pour la première étape, pour le laminage de la face avant du module photovoltaïque, éventuellement combinée à la présence d'une couche intermédiaire dite « amortissante » permettant le collage de la face avant du module sur le matériau d'encapsulation et l'amortissement des contraintes thermiques, peuvent permettre de limiter, voire d'empêcher, la dilatation thermique.

Alternativement, l'invention a aussi pour objet, selon un autre de ses aspects, un procédé de réalisation d'un ensemble de structure photovoltaïque tel que défini précédemment, comportant au moins les trois étapes successives suivantes de :
a) laminage à chaud à une température supérieure ou égale à 150°C de l'ensemble des couches constitutives du module photovoltaïque,
b) application d'une couche de revêtement sur la première couche formant la face avant du module photovoltaïque, notamment pour permettre le passage de piétons et/ou de véhicules, la couche de revêtement étant non opaque et présentant une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV (pour « Polished Stone Value » en anglais) selon la norme NF EN 13043 d'au moins PSV₄₄, mieux PSV₅₀, encore mieux PSV₅₃,
c) fixation du module photovoltaïque sur une zone circulable pour former l'ensemble de structure photovoltaïque, au moyen d'une couche de fixation de l'ensemble de structure photovoltaïque, constituée notamment par une colle bitumeuse ou par une ou des résines acryliques.

L'ensemble de structure photovoltaïque et le procédé selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DU DESSIN

L'invention pourra être mieux comprise à la lecture de la description détaillée qui va suivre, d'un exemple de mise en oeuvre non limitatif de celle-ci, ainsi qu'à l'examen de la figure unique, schématique et partielle, du dessin annexé, illustrant, en coupe et en vue éclatée, un exemple de réalisation d'un ensemble de structure photovoltaïque conforme à l'invention.

Sur cette figure unique, les différentes parties représentées ne le sont pas nécessairement selon une échelle uniforme, pour rendre la figure plus lisible.

### EXPOSÉ DÉTAILLÉ D'UN MODE DE RÉALISATION PARTICULIER

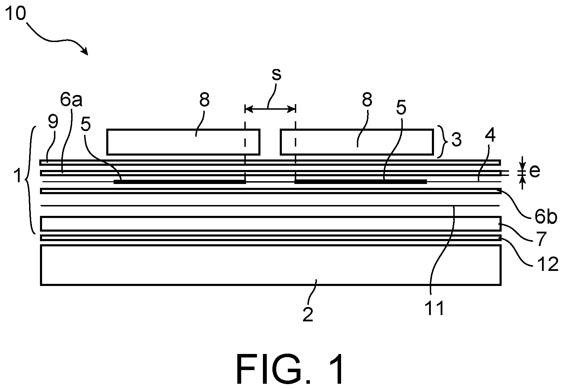

Il est fait ci-après référence à la figure 1, illustrant en coupe et en vue éclatée un exemple de réalisation d'un ensemble 10 de structure photovoltaïque conforme à l'invention.

Il est à noter que la figure 1 correspond à une vue éclatée de l'ensemble 10 de structure photovoltaïque avant les étapes de laminage du procédé selon l'invention. Une fois les étapes de laminage réalisées, les différentes couches sont en réalité superposées les unes aux autres, mais aussi un peu déformées de sorte qu'au moins les plaques 8 de la première couche 3 s'enfoncent dans l'ensemble formé par la couche intermédiaire 9 et l'ensemble encapsulant 6a, 6b qui se déforment. Les étapes de laminage assurent un pressage à chaud et sous vide. Selon les épaisseurs des différentes couches, les plaques 8 peuvent affleurer ou non sur le module photovoltaïque 1, le matériau de la couche intermédiaire 9 et peut-être celui de l'ensemble encapsulant 6a, 6b pouvant également combler au moins une partie des espaces entre les plaques 8.

Comme expliqué précédemment, le module photovoltaïque 1 conforme à l'invention est conçu pour être suffisamment flexible afin de pouvoir l'appliquer, notamment par collage, sur une zone circulable 2, en particulier une chaussée, pouvant présenter une rugosité de surface, autrement dit pas nécessairement plan et lisse. De plus, le module photovoltaïque 1 conforme à l'invention est également prévu pour résister à des pressions statiques ou dynamiques pouvant aller jusqu'à 1500 kN/m², voire 5000 kN/m². La zone circulable 2 est de manière avantageuse suffisamment rigide pour ne pas se déformer lorsqu'on applique la même contrainte que celle appliquée au module photovoltaïque 1.

Comme on peut ainsi le voir sur la figure 1, le module photovoltaïque 1 comporte une première couche 3 transparente formant la face avant du module 1 destinée à recevoir un flux lumineux, un ensemble encapsulant 6a, 6b, obtenu par la fusion de deux couches de matériau d'encapsulation supérieure 6a et inférieure 6b, un ensemble 4 de cellules photovoltaïques 5 pris entre deux couches de matériau d'encapsulation supérieure 6a et inférieure 6b, et une deuxième couche 7 formant la face arrière du module photovoltaïque 1 destinée à être collée à la zone circulable 2.

Les deux couches de matériau d'encapsulation 6a et 6b formant l'ensemble encapsulant, ainsi que l'éventuelle couche intermédiaire 9 décrite par la suite, forment une structure relativement souple pouvant être réalisée à partir d'un seul matériau ou de plusieurs matériaux en cas d'incompatibilité chimique.

Conformément à l'invention, la première couche 3 est constituée d'un matériau polymère transparent et comporte une pluralité de plaques 8 indépendantes les unes des autres, chaque plaque 8 étant située en regard d'une cellule photovoltaïque 5, de sorte à former une face avant discontinue du module photovoltaïque 1.

Le matériau polymère transparent de la première couche 3 peut par exemple être choisi parmi du polycarbonate (PC), du polyméthacrylate de méthyle (PMMA), de l'éthylène tétrafluoroéthylène (ETFE), ou du polyfluorure de vinylidène (PVDF), entre autres. De plus, l'épaisseur de la première couche 3 peut être supérieure à 0,1 mm, et idéalement comprise entre 0,5 et 6 mm. Dans cet exemple, la première couche 3 est ainsi constituée de plusieurs plaques 8, de dimensions égales à 162 x 162 mm, de PMMA d'épaisseur égale à 3 mm.

Par ailleurs, les cellules photovoltaïques 5 sont interconnectées électriquement les unes avec les autres avec un espacement s entre deux cellules 5 voisines égal à environ 15 mm. Les cellules photovoltaïques 5 peuvent être des cellules dites « cristallines », c'est-à-dire à base de cristaux de silicium ou de polycristaux de silicium, avec une homojonction ou hétérojonction, et d'épaisseur inférieure ou égale à 250 µm. De plus, dans cet exemple, chaque plaque 8 s'étend en superposition de part et d'autre de la cellule photovoltaïque 5 sous-jacente sur une distance d'environ 3 mm, de sorte que l'espacement entre deux plaques 8 adjacentes est ici égal à l'espacement s entre deux cellules 5 voisines diminué d'environ 2 fois 3 mm, soit environ 6 mm.

En outre, la rigidité de chaque couche de matériau d'encapsulation 6a et 6b est définie par un module de Young E à température ambiante du matériau d'encapsulation supérieur ou égal à 50 MPa, voire 75 MPa, voire encore 100 MPa, de préférence supérieur ou égal à 200 MPa, et une épaisseur e de la couche 6a, 6b comprise entre 0,2 et 1 mm.

Les couches de matériau d'encapsulation 6a et 6b forment un ensemble encapsulant préférentiellement choisi pour être un ionomère tel que le ionomère commercialisé sous le nom de ionomère jurasol® de type DG3 par la société Jura-plast ou le ionomère commercialisé sous le nom de PV5414 par la société Du Pont, présentant un module de Young à température ambiante supérieur ou égal à 200 MPa et une épaisseur d'environ 500 µm.

La deuxième couche 7 formant la face arrière du module photovoltaïque 1 est quant à elle constituée par un matériau polymère tel que des résines thermodurcissables comme des résines à base époxy, transparent ou non, ou un matériau composite, par exemple du type polymère/fibres de verre. Dans cet exemple, la deuxième couche 7 est constituée par un matériau composite du type polymère/fibres de verre, notamment un tissu à base de polypropylène et de fibres de verre avec un taux de fibres de verre de 60 % en masse, tel que le Thermopreg® fabric P-WRt-1490-PP60W commercialisé par la société Owens Corning Vetrotex, ayant une épaisseur d'environ 1 mm et un module de Young à température ambiante d'environ 12 GPa.

Par ailleurs, une couche adhésive 11, ou encore compatibilisante (sa présence étant justifiée en cas d'incompatibilité chimique), est située entre la deuxième couche 7 formant la face arrière du module photovoltaïque 1 et l'ensemble encapsulant formé par les deux couches de matériau d'encapsulation 6a et 6b de part et d'autre de l'ensemble 4 de cellules photovoltaïques 5. Cette couche adhésive ou compatibilisante 11 permet le collage de la deuxième couche 7 sur la couche de matériau d'encapsulation inférieure 6b. Dans le cas de l'utilisation du Thermopreg® fabric P-WRt-1490-PP60W pour la deuxième couche 7, la couche compatibilisante 11 est préférentiellement choisie pour être un film du type Mondi TK41001 ayant une épaisseur d'environ 50 µm.

De plus, comme on peut le voir sur la figure 1, le module photovoltaïque 1 comporte également une couche intermédiaire 9 dite « amortissante » située entre la première couche 3 et l'ensemble encapsulant formé par les deux couches de matériau d'encapsulation 6a et 6b de part et d'autre de l'ensemble 4 de cellules photovoltaïques 5.

La couche intermédiaire 9 permet le collage de la première couche 3 sur la couche de matériau d'encapsulation supérieure 6a.

La couche intermédiaire 9 est par exemple constituée par un encapsulant standard utilisé dans le domaine du photovoltaïque, tel que le copolymère de l'éthylène-acétate de vinyle (EVA), une polyoléfine, du silicone, du polyuréthane thermoplastique, du polyvinyle de butyral, entre autres. Elle peut encore être constituée par une résine liquide de type acrylique, silicone ou polyuréthane, monocomposant ou bicomposant, réticulable à chaud ou photochimiquement. Elle peut également être constituée par un adhésif sensible à la pression du type PSA (pour « Pressure-Sensitive Adhésive » en anglais).

Dans cet exemple, la couche intermédiaire 9 est constituée par un film thermoplastique, à savoir du polyuréthane thermoplastique connu également sous l'acronyme anglo-saxon TPU, tel que le TPU de type TPU Dureflex® A4700 commercialisé par la société Bayer ou le PX1001 commercialisé par la société American Polyfilm, d'épaisseur égale à environ 380 µm.

La couche intermédiaire 9 permet de remplir deux fonctions principales. D'une part, elle permet l'adhésion de la première couche 3 sur la couche de matériau d'encapsulation supérieure 6a pour le cas où les deux couches ne sont pas compatibles chimiquement. D'autre part, elle permet de créer au sein du module photovoltaïque 1 une couche « amortissante » d'une certaine souplesse permettant d'améliorer la résistance aux chocs et aux charges mécaniques du module 1.

Par ailleurs, l'ensemble 10 de structure photovoltaïque conforme à l'invention représenté sur la figure 1 comporte également une zone circulable 2. La zone circulable 2 peut être de rigidité variable. Dans cet exemple, elle correspond tout particulièrement à une surface en enrobé du type chaussée.

Afin de permettre le collage du module photovoltaïque 1 sur la zone circulable 2, l'ensemble 10 comporte également une couche de fixation 12. Cette couche de fixation 12 est constituée par une colle bitumeuse permettant de faire adhérer le module 1 à la chaussée ou route. Dans cet exemple, il s'agit d'un bitume du type CoIFlex N commercialisé par la société Colas, avec un dosage de 1 kg/m². L'utilisation d'une colle bitumeuse 12 associée à une face arrière 7 du module 1 en un matériau composite peut permettre de renforcer la face arrière 7 de sorte à éviter le risque de poinçonnement des cellules photovoltaïques 5 soumis au passage de piétons et/ou de véhicules sur une chaussée 2 rugueuse. La colle bitumeuse 12 joue ainsi le rôle d'un liant de protection comblant l'interface entre la chaussée 2 et la face arrière 7 du module 1.

En outre, bien que non représenté sur la figure 1, l'ensemble 10 de structure photovoltaïque comporte également une couche de revêtement appliquée sur la première couche 3, destinée à faciliter la circulation de piétons et/ou de véhicules.

La couche de revêtement est non opaque et présente une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV selon la norme NF EN 13043 d'au moins PSV₄₄, voire PSV₅₀, voire encore PSV₅₃.

On va maintenant décrire un procédé de réalisation d'un ensemble 10 de structure photovoltaïque conforme à l'invention.

Le procédé comporte une première étape a) de laminage à chaud à une température d'environ 170°C et sous vide (pression inférieure ou égale à 10 mbar) des couches constitutives 6a, 4, 6b, 11 et 7 du module photovoltaïque 1 hormis la première couche 3 et la couche intermédiaire 9. Cette première étape a) de laminage est réalisée pendant environ 15 minutes de manière à obtenir un « laminé » de cellules photovoltaïques 5 encapsulées. Les paramètres du laminage, tels que la température, le temps et la pression, peuvent toutefois dépendre du matériau encapsulant utilisé.

Puis, le procédé comporte une deuxième étape b) de laminage à chaud à une température d'environ 125°C et sous vide du « laminé » obtenu au cours de la première étape a) avec la première couche 3 formant la face avant du module photovoltaïque 1 à l'aide de la couche intermédiaire 9. Cette deuxième étape b) est réalisée pendant une durée d'environ 30 minutes de façon à obtenir le module photovoltaïque 1. Avant la mise en oeuvre de cette deuxième étape b), les plaques 8 de la première couche 3 peuvent avantageusement être traitées à l'aide d'un équipement de traitement Corona de manière à obtenir une énergie de surface supérieure ou égale à 48 dyn/cm.

Ces première a) et deuxième b) étapes de laminage sont ensuite suivies d'une étape c) d'application d'une couche de revêtement sur la première couche 3 pour permettre le passage de piétons et/ou de véhicules, la couche de revêtement étant telle que décrite précédemment. Enfin, une étape de fixation d) du module photovoltaïque 1 sur la zone circulable 2 permet de former l'ensemble 10 de structure photovoltaïque. Cette étape de fixation est avantageusement mise en oeuvre à l'aide d'une colle bitumeuse appliquée entre la zone circulable 2 et le module 1.

Des essais ont pu être réalisés avec différents modules photovoltaïques 1, comportant de 3 à 40 cellules photovoltaïques 5, selon le procédé décrit ci-dessus. La tenue à la charge mécanique de ces modules 1, collés sur un enrobé de route 2, avec des pressions allant jusqu'à 500 kN/m² en statique et en dynamique, a pu être démontrée. Par exemple, un module photovoltaïque 1, constitué de trois cellules photovoltaïques 5, n'a subi aucune dégradation après environ 64000 applications d'une pression de 500 kN/m².

Par conséquent, le module photovoltaïque 1 peut présenter une résistance mécanique accrue adaptée à des applications contraignantes en termes de sollicitations mécaniques, comme du type de la route solaire, mais également présenter une flexibilité par morceaux du fait de la présence d'une face avant 3 discontinue, lui permettant de prendre différentes formes pour s'adapter à différents types de surfaces, par exemple accidentées ou de planéité imparfaite. De plus, la présence d'une face arrière 7 renforcée peut permettre d'améliorer la résistance au poinçonnement de cette face arrière 7 du module 1, ce poinçonnement pouvant résulter de la rugosité du support 2 sur lequel le module 1 est appliqué et pouvant conduire à des fissures des cellules photovoltaïques 5 du module photovoltaïque 1.

Bien entendu, l'invention n'est pas limitée à l'exemple de réalisation qui vient d'être décrit. Diverses modifications peuvent y être apportées par l'homme du métier.

L'expression « comportant un » doit être comprise comme étant synonyme de « comportant au moins un », sauf si le contraire est spécifié.

## Revendications

1. Ensemble (10) de structure photovoltaïque, comportant :
- une zone circulable (2),
- un module photovoltaïque (1) appliqué sur la zone circulable (2),
le module photovoltaïque (1) comportant au moins :
- une première couche (3) transparente formant la face avant du module photovoltaïque (1) destinée à recevoir un flux lumineux,
- un ensemble (4) d'une pluralité de cellules photovoltaïques (5) disposées côte à côte et reliées électriquement entre elles,
- un ensemble encapsulant (6a, 6b) la pluralité de cellules photovoltaïques (5),
- une deuxième couche (7) formant la face arrière du module photovoltaïque (1), l'ensemble encapsulant (6a, 6b) et l'ensemble (4) d'une pluralité de cellules photovoltaïques (5) étant situés entre les première (3) et deuxième (7) couches,
et
- une couche de fixation (12), constituée notamment par une colle bitumeuse ou par une ou des résines acryliques, située entre la zone circulable (2) et le module photovoltaïque (1), permettant l'adhérence du module photovoltaïque (1) à la zone circulable (2),
**caractérisé en ce que** la première couche (3) est constituée d'au moins un matériau polymère transparent et comporte une pluralité de plaques (8) indépendantes les unes des autres, chaque plaque (8) étant située en regard d'au moins une cellule photovoltaïque (5), de sorte à former une face avant discontinue du module photovoltaïque (1),
et **en ce que** la rigidité de l'ensemble encapsulant (6a, 6b) est définie par un module de Young (E) du matériau d'encapsulation supérieur ou égal à 75 MPa à température ambiante et une épaisseur (e) de l'ensemble encapsulant (6a, 6b) comprise entre 0,4 et 1 mm.

2. Ensemble selon la revendication 1, **caractérisé en ce qu'**il comporte une couche de revêtement, permettant notamment le passage de piétons et/ou de véhicules, appliquée sur la première couche (3) formant la face avant du module photovoltaïque (1), la couche de revêtement étant non opaque et présentant une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV selon la norme NF EN 13043 d'au moins PSV₄₄, mieux PSV₅₀, encore mieux PSV₅₃.

3. Ensemble selon la revendication 1 ou 2, **caractérisé en ce que** la zone circulable (2) est prévue pour la circulation de piétons et/de véhicules, étant notamment une chaussée.

4. Ensemble selon l'une des revendications précédentes, **caractérisé en ce que** le matériau d'encapsulation des couches formant l'ensemble encapsulant (6a, 6b) présente un module de Young (E) à température ambiante supérieur ou égal à 100 MPa, de préférence supérieur ou égal à 150 MPa, de préférence supérieur ou égal à 200 MPa, notamment égal à 220 MPa.

5. Ensemble selon l'une quelconque des revendications précédentes, **caractérisé en ce que** la deuxième couche (7) formant la face arrière du module photovoltaïque (1) est constituée d'au moins un matériau composite, notamment du type polymère/fibres de verre.

6. Ensemble selon l'une des revendications précédentes, **caractérisé en ce que** la rigidité de la deuxième couche (7) formant la face arrière du module photovoltaïque (1) est définie par un facteur de rigidité, correspondant au module de Young (E) à température ambiante du matériau de la deuxième couche (7) multiplié par l'épaisseur de la deuxième couche (7), compris entre 5 et 15 GPa.mm.

7. Ensemble selon l'une quelconque des revendications précédentes, **caractérisé en ce que** l'espacement (s) entre deux cellules photovoltaïques (5) voisines est supérieur ou égal à 1 mm, notamment compris entre 1 et 30 mm, et de préférence supérieur ou égal à 3 mm, notamment compris entre 10 et 20 mm.

8. Ensemble selon l'une quelconque des revendications précédentes, **caractérisé en ce que** le module photovoltaïque (1) comporte une couche intermédiaire (9) dite « amortissante » située entre la première couche (3) formant la face avant du module photovoltaïque (1) et l'ensemble encapsulant (6a, 6b) la pluralité de cellules photovoltaïques (5), permettant l'assemblage, notamment par collage, de la première couche (3) sur l'ensemble encapsulant (6a, 6b).

9. Ensemble selon la revendication 8, **caractérisé en ce que** la couche intermédiaire (9) est constituée d'au moins un matériau polymère, notamment d'une résine polymère thermoplastique ou thermodurcissable.

10. Ensemble selon la revendication 8 ou 9, **caractérisé en ce que** la rigidité de la couche intermédiaire (9) est définie par un module de Young (E) à température ambiante du matériau de la couche intermédiaire (9) inférieur ou égal à 50 MPa et une épaisseur de la couche intermédiaire (9) comprise entre 0,01 et 1 mm.

11. Ensemble selon l'une quelconque des revendications précédentes, **caractérisé en ce que** le module photovoltaïque (1) comporte une couche adhésive (11) située entre la deuxième couche (7) formant la face arrière du module photovoltaïque (1) et l'ensemble encapsulant (6a, 6b) formé par deux couches de matériau d'encapsulation (6a, 6b) de part et d'autre de la pluralité de cellules photovoltaïques (5), permettant l'assemblage, notamment par collage, de la deuxième couche (7) sur l'ensemble encapsulant (6a, 6b).

12. Ensemble selon l'une quelconque des revendications précédentes, **caractérisé en ce que** l'épaisseur de la première couche (3) formant la face avant du module photovoltaïque (1) est supérieure ou égale à 0,1 mm, notamment comprise entre 0,5 et 6 mm.

13. Ensemble selon l'une quelconque des revendications précédentes, **caractérisé en ce que** les cellules photovoltaïques (5) sont des cellules dites « cristallines », c'est-à-dire à base de cristaux de silicium ou de polycristaux de silicium.

14. Utilisation, pour son application sur une zone circulable (2), notamment une chaussée, d'un module photovoltaïque (1) comportant au moins :
- une première couche (3) transparente formant la face avant du module photovoltaïque (1) destinée à recevoir un flux lumineux,
- un ensemble (4) d'une pluralité de cellules photovoltaïques (5) disposées côte à côte et reliées électriquement entre elles,
- un ensemble encapsulant (6a, 6b) la pluralité de cellules photovoltaïques (5),
- une deuxième couche (7) formant la face arrière du module photovoltaïque (1), l'ensemble encapsulant (6a, 6b) et l'ensemble (4) d'une pluralité de cellules photovoltaïques (5) étant situés entre les première (3) et deuxième (7) couches, la première couche (3) étant constituée d'au moins un matériau polymère transparent et comportant une pluralité de plaques (8) indépendantes les unes des autres, chaque plaque (8) étant située en regard d'au moins une cellule photovoltaïque (5), de sorte à former une face avant discontinue du module photovoltaïque (1),
et la rigidité de l'ensemble encapsulant (6a, 6b) étant définie par un module de Young (E) du matériau d'encapsulation supérieur ou égal à 75 MPa à température ambiante et une épaisseur (e) de l'ensemble encapsulant (6a, 6b) comprise entre 0,4 et 1 mm,
le module photovoltaïque (1) étant appliqué sur la zone circulable (2) par l'intermédiaire d'une couche de fixation (12), constituée notamment par une colle bitumeuse ou par une ou des résines acryliques.

15. Procédé de réalisation d'un ensemble (10) de structure photovoltaïque selon l'une quelconque des revendications 1 à 13, comportant au moins les quatre étapes successives suivantes de :
a) laminage à chaud à une température supérieure à 150°C de l'ensemble des couches (6a, 4, 6b, 11, 7) constitutives du module photovoltaïque (1) hormis la première couche (3) formant la face avant du module photovoltaïque (1) et une éventuelle couche intermédiaire (9) dite « amortissante », située entre la première couche (3) et l'ensemble encapsulant (6a, 6b) la pluralité de cellules photovoltaïques,
b) laminage à une température inférieure ou égale à 150°C, de préférence 125°C, de la première couche (3) formant la face avant du module photovoltaïque (1), et de l'éventuelle couche intermédiaire (9), sur les couches (6a, 4, 6b, 11, 7) constitutives du module photovoltaïque (1) laminées ensemble au cours de la première étape a),
c) application d'une couche de revêtement sur la première couche (3) formant la face avant du module photovoltaïque (1), notamment pour permettre le passage de piétons et/ou de véhicules, la couche de revêtement étant non opaque et présentant une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV selon la norme NF EN 13043 d'au moins PSV₄₄, mieux PSV₅₀, encore mieux PSV₅₃,
d) fixation du module photovoltaïque (1) sur la zone circulable (2) pour former l'ensemble (10) de structure photovoltaïque, au moyen d'une couche de fixation (12) de l'ensemble (10) de structure photovoltaïque, constituée notamment par une colle bitumeuse ou par une ou des résines acryliques.

16. Procédé de réalisation d'un ensemble (10) de structure photovoltaïque selon l'une quelconque des revendications 1 à 13, comportant au moins les trois étapes successives suivantes de :
a) laminage à chaud à une température supérieure ou égale à 150°C de l'ensemble des couches (3, 9, 6a, 4, 6b, 11, 7) constitutives du module photovoltaïque (1),
b) application d'une couche de revêtement sur la première couche (3) formant la face avant du module photovoltaïque (1), notamment pour permettre le passage de piétons et/ou de véhicules, la couche de revêtement étant non opaque et présentant une surface extérieure texturée et irrégulière, notamment une surface extérieure macrotexturée et microtexturée irrégulièrement, avec une profondeur moyenne de texture PMT mesurée selon la norme NF EN 13036-1 comprise entre 0,2 mm et 3 mm et une valeur de PSV selon la norme NF EN 13043 d'au moins PSV₄₄, mieux PSV₅₀, encore mieux PSV₅₃,
c) fixation du module photovoltaïque (1) sur la zone circulable (2) pour former l'ensemble (10) de structure photovoltaïque, au moyen d'une couche de fixation (12) de l'ensemble (10) de structure photovoltaïque, constituée notamment par une colle bitumeuse ou par une ou des résines acryliques.

## Patentansprüche

1. Anordnung (10) einer Photovoltaikstruktur, umfassend:
- einen befahrbaren Bereich (2),
- ein Photovoltaikmodul (1), das auf den befahrbaren Bereich (2) aufgebracht ist, wobei das Photovoltaikmodul (1) mindestens umfasst:
- eine erste transparente Schicht (3), die die Vorderseite des Photovoltaikmoduls (1) bildet, die dazu bestimmt ist, einen Lichtstrom aufzunehmen,
- eine Anordnung (4) aus einer Vielzahl von Photovoltaikzellen (5), die nebeneinander angeordnet und elektrisch untereinander verbunden sind,
- eine Einkapselungsanordnung (6a, 6b) zum Einkapseln der Vielzahl von Photovoltaikzellen (5),
- eine zweite Schicht (7), die die Rückseite des Photovoltaikmoduls (1) bildet, wobei die Einkapselungsanordnung (6a, 6b) und die Anordnung (4) aus einer Vielzahl von Photovoltaikzellen (5) zwischen der ersten (3) und der zweiten (7) Schicht gelegen sind,
- eine Fixierungsschicht (12), die insbesondere aus einem bituminösen Kleber oder aus einem oder mehreren Acrylharzen besteht, die zwischen dem befahrbaren Bereich (2) und dem Photovoltaikmodul (1) gelegen ist, die die Haftung des Photovoltaikmoduls (1) am befahrbaren Bereich (2) ermöglicht, **dadurch gekennzeichnet, dass** die erste Schicht (3) aus mindestens einem transparenten Polymerwerkstoff besteht und eine Vielzahl von Platten (8) umfasst, die voneinander unabhängig sind, wobei jede Platte (8) gegenüber mindestens einer Photovoltaikzelle (5) gelegen ist, so dass eine diskontinuierliche Vorderseite des Photovoltaikmoduls (1) gebildet wird,
und dass die Steifigkeit der Einkapselungsanordnung (6a, 6b) durch einen Youngschen Modul (E) des Einkapselungswerkstoffs größer als oder gleich 75 MPa bei Umgebungstemperatur und bei einer Dicke (e) der Einkapselungsanordnung (6a, 6b) zwischen 0,4 und 1 mm definiert ist.

2. Anordnung nach Anspruch 1, **dadurch gekennzeichnet, dass** sie eine Deckschicht umfasst, die insbesondere das Passieren von Fußgängern und/oder Fahrzeugen ermöglicht, die auf die erste Schicht (3) aufgebracht ist, die die Vorderseite des Photovoltaikmoduls (1) bildet, wobei die Deckschicht nicht lichtundurchlässig ist und eine texturierte und unregelmäßige Außenoberfläche, insbesondere eine unregelmäßig makrotexturierte und mikrotexturierte Außenoberfläche, mit einer mittleren Texturtiefe MTD, gemessen nach der Norm NF EN 13036-1, zwischen 0,2 mm und 3 mm und einem PSV-Wert gemäß der Norm NF EN 13043 von mindestens PSV44, besser PSV50, noch besser PSV53, aufweist.

3. Anordnung nach Anspruch 1 oder 2, **dadurch gekennzeichnet, dass** der befahrbare Bereich (2) für den Fußgänger- und/oder Fahrzeugverkehr vorgesehen ist, wobei er insbesondere eine Fahrbahn ist.

4. Anordnung nach einem der vorhergehenden Ansprüche, **dadurch gekennzeichnet, dass** der Einkapselungswerkstoff der Schichten, die die Einkapselungsanordnung (6a, 6b) bilden, einen Youngschen Modul (E) bei Umgebungstemperatur größer als oder gleich 100 MPa, bevorzugt größer als oder gleich 150 MPa, bevorzugt größer als oder gleich 200 MPa, insbesondere gleich 220 MPa aufweist.

5. Anordnung nach einem der vorhergehenden Ansprüche, **dadurch gekennzeichnet, dass** die zweite Schicht (7), die die Rückseite des Photovoltaikmoduls (1) bildet, aus mindestens einem Verbundwerkstoff, insbesondere von der Art Polymer/Glasfaser, besteht.

6. Anordnung nach einem der vorhergehenden Ansprüche, **dadurch gekennzeichnet, dass** die Steifigkeit der zweiten Schicht (7), die die Rückseite des Photovoltaikmoduls (1) bildet, durch einen Steifigkeitsfaktor, entsprechend dem Youngschen Modul (E) bei Umgebungstemperatur des Werkstoffs der zweiten Schicht (7) multipliziert mit der Dicke der zweiten Schicht (7), zwischen 5 und 15 GPa.mm definiert wird.

7. Anordnung nach einem der vorhergehenden Ansprüche, **dadurch gekennzeichnet, dass** der Abstand (s) zwischen zwei benachbarten Photovoltaikzellen (5) größer als oder gleich 1 mm ist, insbesondere zwischen 1 und 30 mm liegt, und bevorzugt größer als oder gleich 3 mm ist, insbesondere zwischen 10 und 20 mm liegt.

8. Anordnung nach einem der vorhergehenden Ansprüche, **dadurch gekennzeichnet, dass** das Photovoltaikmodul (1) eine Zwischenschicht (9), "Dämpfungsschicht" genannt, umfasst, die zwischen der ersten Schicht (3), die die Vorderseite des Photovoltaikmoduls (1) bildet, und der Einkapselungsanordnung (6a, 6b) zur Einkapselung der Vielzahl von Photovoltaikzellen (5) gelegen ist, die die Montage, insbesondere durch Kleben, der ersten Schicht (3) auf der Einkapselungsanordnung (6a, 6b) ermöglicht.

9. Anordnung nach Anspruch 8, **dadurch gekennzeichnet, dass** die Zwischenschicht (9) aus mindestens einem Polymerwerkstoff besteht, insbesondere aus einem thermoplastischen oder duroplastischen Polymerharz.

10. Anordnung nach Anspruch 8 oder 9, **dadurch gekennzeichnet, dass** die Steifigkeit der Zwischenschicht (9) durch einen Youngschen Modul (E) kleiner als oder gleich 50 MPa bei Umgebungstemperatur des Werkstoffs der Zwischenschicht (9) und bei einer Dicke der Zwischenschicht (9) zwischen 0,01 und 1 mm definiert wird.

11. Anordnung nach einem der vorhergehenden Ansprüche, **dadurch gekennzeichnet, dass** das Photovoltaikmodul (1) eine Haftschicht (11) umfasst, die zwischen der zweiten Schicht (7), die die Rückseite des Photovoltaikmoduls (1) bildet, und der Einkapselungsanordnung (6a, 6b), die aus zwei Schichten aus Einkapselungswerkstoff (6a, 6b) beidseits der Vielzahl von Photovoltaikzellen (5) gebildet wird, gelegen ist, die die Montage der zweiten Schicht (7) auf der Einkapselungsanordnung (6a, 6b), insbesondere durch Kleben, ermöglicht.

12. Anordnung nach einem der vorhergehenden Ansprüche, **dadurch gekennzeichnet, dass** die Dicke der ersten Schicht (3), die die Vorderseite des Photovoltaikmoduls (1) bildet, größer als oder gleich 0,1 mm ist, insbesondere zwischen 0,5 und 6 mm liegt.

13. Anordnung nach einem der vorhergehenden Ansprüche, **dadurch gekennzeichnet, dass** die Photovoltaikzellen (5) sogenannte "kristalline" Zellen sind, d. h., auf Siliziumkristallen oder Siliziumpolykristallen basieren.

14. Verwendung eines Photovoltaikmoduls (1) zum Aufbringen auf einen befahrbaren Bereich (2), wobei das Photovoltaikmodul mindestens umfasst:
- eine erste transparente Schicht (3), die die Vorderseite des Photovoltaikmoduls (1) bildet, die dazu bestimmt ist, einen Lichtstrom aufzunehmen,
- eine Anordnung (4) aus einer Vielzahl von Photovoltaikzellen (5), die nebeneinander angeordnet und elektrisch untereinander verbunden sind,
- eine Einkapselungsanordnung (6a, 6b) zum Einkapseln der Vielzahl von Photovoltaikzellen (5),
- eine zweite Schicht (7), die die Rückseite des Photovoltaikmoduls (1) bildet, wobei die Einkapselungsanordnung (6a, 6b) und die Anordnung (4) aus einer Vielzahl von Photovoltaikzellen (5) zwischen der ersten Schicht (3) und der zweiten Schicht (7) gelegen sind, wobei die erste Schicht (3) aus mindestens einem transparenten Polymerwerkstoff besteht und eine Vielzahl von voneinander unabhängigen Platten (8) umfasst, wobei jede Platte (8) gegenüber mindestens einer Photovoltaikzelle (5) gelegen ist, so dass eine diskontinuierliche Vorderseite des Photovoltaikmoduls (1) gebildet wird,
und die Steifigkeit der Einkapselungsanordnung (6a, 6b) durch einen Youngschen Modul (E) des Einkapselungswerkstoffs größer als oder gleich 75 MPa bei Umgebungstemperatur und einer Dicke (e) der Einkapselungsanordnung (6a, 6b) zwischen 0,4 und 1 mm definiert wird,
wobei das Photovoltaikmodul (1) auf den befahrbaren Bereich (2) über eine Fixierungsschicht (12) aufgebracht ist, die insbesondere aus einem bituminösen Kleber oder aus einem oder mehreren Acrylharzen besteht.

15. Verfahren zur Ausführung einer Anordnung (10) einer Photovoltaikstruktur nach einem der Ansprüche 1 bis 13, umfassend mindestens die vier folgenden aufeinanderfolgenden Schritte:
a) Warmwalzen der Anordnung der Schichten (6a, 4, 6b, 11, 7), aus denen das Photovoltaikmodul (1) besteht, bis auf die erste Schicht (3), die die Vorderseite des Photovoltaikmoduls (1) bildet, und eine etwaige Zwischenschicht (9), "Dämpfungsschicht" genannt, die zwischen der ersten Schicht (3) und der Einkapselungsanordnung (6a, 6b) zur Einkapselung der Vielzahl von Photovoltaikzellen gelegen ist, bei einer Temperatur größer als 150°C,
b) Walzen der ersten Schicht (3), die die Vorderseite des Photovoltaikmoduls (1) bildet, und der etwaigen Zwischenschicht (9) auf die Schichten (6a, 4, 6b, 11, 7), aus denen das Photovoltaikmodul (1) besteht, die im ersten Schritt a) zusammengewalzt wurden, bei einer Temperatur kleiner als oder gleich 150°C, bevorzugt 125°C,
c) Aufbringen einer Deckschicht auf die erste Schicht (3), die die Vorderseite des Photovoltaikmoduls (1) bildet, insbesondere, um das Passieren von Fußgängern und/oder von Fahrzeugen zu ermöglichen, wobei die Deckschicht nicht lichtundurchlässig ist und eine texturierte und unregelmäßige Außenoberfläche, insbesondere eine unregelmäßig makrotexturierte und mikrotexturierte Außenoberfläche, mit einer mittleren Texturtiefe MTD, gemessen nach der Norm NF EN 13036-1, zwischen 0,2 mm und 3 mm und einem PSV-Wert gemäß der Norm NF EN 13043 von mindestens PSV44, besser PSV50, noch besser PSV53, aufweist,
d) Fixieren des Photovoltaikmoduls (1) auf dem befahrbaren Bereich (2), um die Anordnung (10) einer Photovoltaikstruktur zu bilden, mittels einer Fixierungsschicht (12) zum Fixieren der Anordnung (10) der Photovoltaikstruktur, die insbesondere aus einem bituminösen Kleber oder aus einem oder mehreren Acrylharzen besteht.

16. Verfahren zur Ausführung einer Anordnung (10) einer Photovoltaikstruktur nach einem der Ansprüche 1 bis 13, umfassend mindestens die drei folgenden aufeinanderfolgenden Schritte:
a) Warmwalzen sämtlicher Schichten (3, 9, 6a, 4, 6b, 11, 7), aus denen das Photovoltaikmodul (1) besteht, bei einer Temperatur größer als oder gleich 150°C,
b) Aufbringen einer Deckschicht auf die erste Schicht (3), die die Vorderseite des Photovoltaikmoduls (1) bildet, insbesondere, um das Passieren von Fußgängern und/oder von Fahrzeugen zu ermöglichen, wobei die Deckschicht nicht lichtundurchlässig ist und eine texturierte und unregelmäßige Außenoberfläche, insbesondere eine unregelmäßig makrotexturierte und mikrotexturierte Außenoberfläche, mit einer mittleren Texturtiefe MTD, gemessen nach der Norm NF EN 13036-1, zwischen 0,2 mm und 3 mm und einem PSV-Wert gemäß der Norm NF EN 13043 von mindestens PSV44, besser PSV50, noch besser PSV53, aufweist,
c) Fixieren des Photovoltaikmoduls (1) auf dem befahrbaren Bereich (2), um die Anordnung (10) einer Photovoltaikstruktur zu bilden, mittels einer Fixierungsschicht (12) zum Fixieren der Anordnung (10) der Photovoltaikstruktur, die insbesondere aus einem bituminösen Kleber oder aus einem oder mehreren Acrylharzen besteht.

## Claims

1. Photovoltaic structure assembly (10), comprising:
- a circulable zone (2),
- a photovoltaic module (1) applied to the circulable zone (2),
the photovoltaic module (1) comprising at least:
- a first transparent layer (3) forming the front face of the photovoltaic module (1) intended to receive a luminous flux,
- an assembly (4) of a plurality of photovoltaic cells (5) arranged side by side and electrically connected together,
- an assembly (6a, 6b) encapsulating the plurality of photovoltaic cells (5),
- a second layer (7) forming the rear face of the photovoltaic module (1), the encapsulating assembly (6a, 6b) and the assembly (4) of a plurality of photovoltaic cells (5) being situated between the first (3) and second (7) layers, and
- a fixation layer (12), constituted notably of a bituminous adhesive or one or more acrylic resins, situated between the circulable zone (2) and the photovoltaic module (1), enabling the adherence of the photovoltaic module (1) to the circulable zone (2), **characterised in that** the first layer (3) is constituted of at least one transparent polymer material and comprises a plurality of panels (8) independent of each other, each panel (8) being situated facing at least one photovoltaic cell (5), so as to form a discontinuous front face of the photovoltaic module (1),
and **in that** the rigidity of the encapsulating assembly (6a, 6b) is defined by a Young's modulus (E) of the encapsulation material greater than or equal to 75 MPa at ambient temperature and a thickness (e) of the encapsulating assembly (6a, 6b) comprised between 0.4 and 1 mm.

2. Assembly according to claim 1, **characterised in that** it comprises a covering layer, notably enabling the passage of pedestrians and/or vehicles, applied to the first layer (3) forming the front face of the photovoltaic module (1), the covering layer being non-opaque and having a textured and irregular outer surface, notably an irregularly macrotextured and microtextured outer surface, with a mean texture depth MTD measured according to the NF EN 13036-1 standard comprised between 0.2 mm and 3 mm and a PSV value according to the NF EN 13043 standard of at least PSV₄₄, better PSV₅₀, even better PSV₅₃.

3. Assembly according to claim 1 or 2, **characterised in that** the circulable zone (2) is provided for the circulation of pedestrians and/or vehicles, being notably a roadway.

4. Assembly according to one of the preceding claims, **characterised in that** the encapsulation material of the layers forming the encapsulating assembly (6a, 6b) has a Young's modulus (E) at ambient temperature greater than or equal to 100 MPa, preferably greater than or equal to 150 MPa, preferably greater than or equal to 200 MPa, notably equal to 220 MPa.

5. Assembly according to any of the preceding claims, **characterised in that** the second layer (7) forming the rear face of the photovoltaic module (1) is constituted of at least one composite material, notably of the polymer/glass fibre type.

6. Assembly according to one of the preceding claims, **characterised in that** the rigidity of the second layer (7) forming the rear face of the photovoltaic module (1) is defined by a rigidity factor, corresponding to the Young's modulus (E) at ambient temperature of the material of the second layer (7) multiplied by the thickness of the second layer (7), comprised between 5 and 15 GPa.mm.

7. Assembly according to any of the preceding claims, **characterised in that** the spacing(s) between two neighbouring photovoltaic cells (5) is greater than or equal to 1 mm, notably comprised between 1 and 30 mm, and preferably greater than or equal to 3 mm, notably comprised between 10 and 20 mm.

8. Assembly according to any of the preceding claims, **characterised in that** the photovoltaic module (1) comprises a so-called "cushioning" intermediate layer (9) situated between the first layer (3) forming the front face of the photovoltaic module (1) and the assembly (6a, 6b) encapsulating the plurality of photovoltaic cells (5), enabling the assembly, notably by bonding, of the first layer (3) on the encapsulating assembly (6a, 6b).

9. Assembly according to claim 8, **characterised in that** the intermediate layer (9) is constituted of at least one polymer material, notably a thermoplastic or thermosetting polymer resin.

10. Assembly according to claim 8 or 9, **characterised in that** the rigidity of the intermediate layer (9) is defined by a Young's modulus (E) at ambient temperature of the material of the intermediate layer (9) less than or equal to 50 MPa and a thickness of the intermediate layer (9) comprised between 0.01 and 1 mm.

11. Assembly according to any of the preceding claims, **characterised in that** the photovoltaic module (1) comprises an adhesive layer (11) situated between the second layer (7) forming the rear face of the photovoltaic module (1) and the encapsulating assembly (6a, 6b) formed by two layers of encapsulation material (6a, 6b) on either side of the plurality of photovoltaic cells (5), enabling the assembly, notably by bonding, of the second layer (7) on the encapsulating assembly (6a, 6b).

12. Assembly according to any of the preceding claims, **characterised in that** the thickness of the first layer (3) forming the front face of the photovoltaic module (1) is greater than or equal to 0.1 mm, notably comprised between 0.5 and 6 mm.

13. Assembly according to any of the preceding claims, **characterised in that** the photovoltaic cells (5) are so-called "crystalline" cells, that is to say based on silicon crystals or silicon polycrystals.

14. Use, for the application thereof on a circulable zone (2), notably a roadway, of a photovoltaic module (1) comprising at least:
- a first transparent layer (3) forming the front face of the photovoltaic module (1) intended to receive a luminous flux,
- an assembly (4) of a plurality of photovoltaic cells (5) arranged side by side and electrically connected together,
- an assembly (6a, 6b) encapsulating the plurality of photovoltaic cells (5),
- a second layer (7) forming the rear face of the photovoltaic module (1), the encapsulating assembly (6a, 6b) and the assembly (4) of a plurality of photovoltaic cells (5) being situated between the first (3) and second (7) layers,
the first layer (3) being constituted of at least one transparent polymer material and comprising a plurality of panels (8) independent of each other, each panel (8) being situated facing at least one photovoltaic cell (5), so as to form a discontinuous front face of the photovoltaic module (1),
and the rigidity of the encapsulating assembly (6a, 6b) being defined by a Young's modulus (E) of the encapsulation material greater than or equal to 75 MPa at ambient temperature and a thickness (e) of the encapsulating assembly (6a, 6b) comprised between 0.4 and 1 mm,
the photovoltaic module (1) being applied to the circulable zone (2) through the intermediary of a fixation layer (12), constituted notably of a bituminous adhesive or one or more acrylic resins.

15. Method for producing a photovoltaic structure assembly (10) according to any of claims 1 to 13, comprising at least the following four successive steps of:
a) hot rolling at a temperature greater than 150°C of the assembly of the layers (6a, 4, 6b, 11, 7) constituting the photovoltaic module (1) apart from the first layer (3) forming the front face of the photovoltaic module (1) and a potential so-called "cushioning" intermediate layer (9), situated between the first layer (3) and the assembly (6a, 6b) encapsulating the plurality of photovoltaic cells,
b) rolling at a temperature less than or equal to 150°C, preferably 125°C, of the first layer (3) forming the front face of the photovoltaic module (1), and the potential intermediate layer (9), on the layers (6a, 4, 6b, 11, 7) constituting the photovoltaic module (1) rolled together during the first step a),
c) application of a covering layer on the first layer (3) forming the front face of the photovoltaic module (1), notably to enable the passage of pedestrians and/or vehicles, the covering layer being non-opaque and having a textured and irregular outer surface, notably an irregularly macrotextured and microtextured outer surface, with a mean texture depth MTD measured according to the NF EN 13036-1 standard comprised between 0.2 mm and 3 mm and a PSV value according to the NF EN 13043 standard of at least PSV₄₄, better PSV₅₀, even better PSV₅₃,
d) fixation of the photovoltaic module (1) on the circulable zone (2) to form the photovoltaic structure assembly (10), by means of a layer (12) for fixing the photovoltaic structure assembly (10), constituted notably of a bituminous adhesive or one or more acrylic resins.

16. Method for producing a photovoltaic structure assembly (10) according to any of claims 1 to 13, comprising at least the following three successive steps of:
a) hot rolling at a temperature greater than or equal to 150°C of the assembly of the layers (3, 9, 6a, 4, 6b, 11, 7) constituting the photovoltaic module (1),
b) application of a covering layer on the first layer (3) forming the front face of the photovoltaic module (1), notably to enable the passage of pedestrians and/or vehicles, the covering layer being non-opaque and having a textured and irregular outer surface, notably an irregularly macrotextured and microtextured outer surface, with a mean texture depth MTD measured according to the NF EN 13036-1 standard comprised between 0.2 mm and 3 mm and a PSV value according to the NF EN 13043 standard of at least PSV₄₄, better PSV₅₀, even better PSV₅₃,
c) fixation of the photovoltaic module (1) on the circulable zone (2) to form the photovoltaic structure assembly (10), by means of a layer (12) for fixing the photovoltaic structure assembly (10), constituted notably of a bituminous adhesive or one or more acrylic resins.
